(19) Europäisches Patentamt
European Patent Office
Office européen des brevets

(11) **EP 4 063 882 B1**

(12) **EUROPÄISCHE PATENTSCHRIFT**

(45) Veröffentlichungstag und Bekanntmachung des Hinweises auf die Patenterteilung:
**14.02.2024   Patentblatt 2024/07**

(21) Anmeldenummer: **21164160.0**

(22) Anmeldetag: **23.03.2021**

(51) Internationale Patentklassifikation (IPC):
**G01R 31/367** *(2019.01)*     **G01R 31/392** *(2019.01)*

(52) Gemeinsame Patentklassifikation (CPC):
**G01R 31/367; G01R 31/392**

(54) **VERFAHREN ZUM BESTIMMEN EINES KAPAZITÄTSVERLUSTS EINES BATTERIESPEICHERS, VORRICHTUNG UND COMPUTERPROGRAMMPRODUKT**

METHOD FOR DETERMINING A CAPACITY LOSS OF A BATTERY STORAGE DEVICE, DEVICE AND COMPUTER PROGRAM PRODUCT

PROCÉDÉ DE DÉTERMINATION D'UNE PERTE DE CAPACITÉ D'UN ACCUMULATEUR DE BATTERIE, DISPOSITIF ET PRODUIT PROGRAMME INFORMATIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**28.09.2022   Patentblatt 2022/39**

(73) Patentinhaber: **Siemens Aktiengesellschaft**
**80333 München (DE)**

(72) Erfinder: **Arzberger, Arno**
**96135 Stegaurach (DE)**

(74) Vertreter: **Siemens Patent Attorneys**
**Postfach 22 16 34**
**80506 München (DE)**

(56) Entgegenhaltungen:
**US-A1- 2014 232 411     US-A1- 2016 003 917**
**US-A1- 2018 149 709**

- **YANZHI WANG ET AL: "Minimizing state-of-health degradation in hybrid electrical energy storage systems with arbitrary source and load profiles", DESIGN, AUTOMATION & TEST IN EUROPE, EUROPEAN DESIGN AND AUTOMATION ASSOCIATION, IMEC VZW, KAPELDREEF 75 LEUVEN BELGIUM, 24. März 2014 (2014-03-24), Seiten 1-4, XP058048464, ISBN: 978-3-9815370-2-4**

**Beschreibung**

Verfahren zum Bestimmen eines Kapazitätsverlusts eines Batteriespeichers, Vorrichtung und Computerprogrammprodukt Die Erfindung betrifft ein Verfahren zum Bestimmen eines Kapazitätsverlusts eines Batteriespeichers, eine Vorrichtung zum Durchführen des Verfahrens und ein Computerprogrammprodukt.

Lithium-Ionen-Akkumulatoren, im Folgenden auch Lithium-Ionen-Batterien genannt, werden aufgrund ihrer hohen Leistungs- und Energiedichte in mobilen und stationären Anwendungen als Energiespeicher eingesetzt. Um diese elektrochemischen Energiespeicher sicher, zuverlässig und möglichst lang wartungsfrei betreiben zu können, ist eine möglichst genaue Kenntnis kritischer Betriebszustände, insbesondere hinsichtlich des Ladezustands (engl.: State of Charge) und hinsichtlich des Alterungszustands (engl: State of Health), nötig.

Die Druckschrift YANZHI WANG ET AL: "Minimizing state-of-health degradation in hybrid electrical energy storage systems with arbitrary source and load profiles", DESIGN, AUTOMATION & TEST IN EUROPE, EUROPEAN DESIGN AND AUTOMATION ASSOCIATION, IMEC VZW, KAPELDREEF 75 LEUVEN BELGIUM, 24. März 2014 (2014-03-24), Seiten 1-4, ISBN: 978-3-9815370-2-4 offenbart ein Verfahren zum Ermitteln eines Kapazitätsverlusts eines Batteriespeichers indem einen Differenzwert zwischen einem hohen Ladezustandwert und einem niedrigen Ladezustandwert bestimmt wird.

Es ist bekannt, dass die Alterung einer Batterie, insbesondere die sogenannte zyklische Alterung durch hohe Temperaturen, das schnelle Laden bei niedrigen Temperaturen, in Abhängigkeit des Ladezustands und der Entladetiefe und der Ladeleistung und Entladeleistung negativ beeinflusst werden kann. Es ist somit möglich, dass derselbe Typ einer Batteriezelle in Abhängigkeit der genannten Parameter eine große unterschiedliche Anzahl von Lastzyklen bewerkstelligen kann.

Zur Bestimmung des erwartbaren Alterungsverlaufs wird im Stand der Technik mittels Messungen während der Auslegungsphase eines Batteriesystems eine Alterungscharakteristik der verwendeten Batteriezelle bestimmt. Die reale Alterungsgeschwindigkeit mit realen Lastprofilen wird häufig nicht getestet. Vielmehr wird in sogenannten Rafftests die Alterungsgeschwindigkeit, oder die Zyklenstabilität, an komprimierten Lastprofilen bestimmt. Mit diesen Ergebnissen werden empirische Alterungsmodelle parametriert, aus welchen der Alterungsverlauf in der Anwendung hervorgeht. Eine basierend auf physikalischen und/oder chemischen Messungen ermittelter Verlauf der zukünftigen Alterung in Abhängigkeit des Lastprofils, des Arbeitspunkts und der Umgebungsbedingungen ist aufgrund der Nichtlinearität der zugrundeliegenden physikalischen und chemischen Prozesse und deren komplexen Wechselwirkungen nur schwer durchzuführen.

Die Vorhersage des Alterungszustands einer Batterie gestaltet sich nachteilig komplex. Häufig ist die Parametrierung eines aussagekräftigen Alterungsmodells somit nachteilig sehr zeitaufwendig. Weiterhin müssen häufig Annahmen zum Bewerten einer Alterung getroffen werden, welche diese nachteilig ungenau machen.

Dies hat nachteilig zur Folge, dass Batteriespeicher größer dimensioniert werden als es die Leistungs- und Lebensdaueranforderungen erfordern, um eine ausreichende Leistung zu gewährleisten und somit Haftungs- und Gewährleistungszusagen einhalten zu können.

Es ist somit Aufgabe der Erfindung ein Verfahren und eine Vorrichtung anzugeben, welche es auf einfache und robuste Weise ermöglichen, den Alterungszustand von Batteriezellen zu ermitteln.

Die Aufgabe wird mit einem Verfahren zum Ermitteln eines Kapazitätsverlusts gemäß Anspruch 1, einer Vorrichtung gemäß Anspruch 11 und einem Computerprogrammprodukt gemäß Anspruch 15 gelöst.

Das erfindungsgemäße Verfahren zum Ermitteln wenigstens eines mittleren Kapazitätsverlusts eines Batteriespeichers umfasst mehrere Schritte. In einem ersten Schritt a) erfolgt das Messen wenigstens zweier Lastzyklen des Batteriespeichers mittels einer Hoch-Präzisions-Coulometrie-Vorrichtung, wobei ein einzelner Lastzyklus ein erstes Entladen umfasst bei dem eine erste Ladungsmenge von einem ersten Ladungszustand zu einem zweiten Ladungszustand gemessen wird. Es erfolgt ein sich anschließendes erstes Laden, bei dem eine zweite Ladungsmenge von dem zweiten Ladungszustand zu einem dritten Ladungszustand gemessen wird. Anschließend erfolgt ein zweites Entladen, bei dem eine dritte Ladungsmenge von dem dritten Ladungszustand zu einem vierten Ladungszustand gemessen wird. Das Laden und Entladen im Lastzyklus erfolgen zwischen einer unteren Spannung und einer oberen Spannung des Batteriespeichers. In einem zweiten Schritt b) erfolgt das Bestimmen einer ersten Ladungsverschiebung mittels einer Differenz des vierten Ladungszustands und des zweiten Ladungszustands und dem Bestimmen einer zweiten Ladungsverschiebung mittels einer Differenz des dritten Ladungszustands und des ersten Ladungszustands. In einem dritten Schritt c) erfolgt das Bestimmen eines Kapazitätsverlusts aus der Differenz der ersten Ladungsverschiebung und der zweiten Ladungsverschiebung, wobei der erste Schritt a), der zweite Schritt b) und der dritte Schritt c) durchgeführt werden, bis der Kapazitätsverlust im Wesentlichen konstant ist. Anschließend wird der mittlere Kapazitätsverlust basierend auf wenigstens zwei Kapazitätsverlusten ermittelt.

Die erfindungsgemäße Vorrichtung zum Durchführen eines Verfahrens zum Bestimmen des mittleren Kapazitätsverlusts eines Batteriespeichers umfasst eine Hoch-Präzisions-Coulometrie-Vorrichtung. Die Hoch-Präzisions-Coulometrie-Vorrichtung ist eingerichtet, einen Lastzyklus des Batteriespeichers messtechnisch zu erfassen. Dabei wird innerhalb des Lastzyklus ein erstes Entladen durchgeführt, bei dem eine erste Ladungsmenge von einem ersten Ladungszustand zu einem zweiten Ladungszustand gemessen wird. Ein sich anschließendes erstes Laden, bei dem eine zweite Ladungsmenge von dem zweiten Ladungszustand zu einem dritten Ladungszustand erfolgt, wird gemessen. Anschließend erfolgt ein zweites Entladen, bei dem eine dritte Ladungsmenge von dem dritten Ladungszustand zu einem vierten Ladungszustand gemessen wird. Das Laden und Entladen im Lastzyklus erfolgen zwischen einer unteren Spannung und einer oberen Spannung des Batteriespeichers. Die Vorrichtung umfasst weiterhin eine Recheneinheit, welche eingerichtet ist, eine erste Ladungsverschiebung mittels einer Differenz des vierten Ladungszustands und des zweiten Ladungszustands zu bestimmen. Die Recheneinheit ist weiterhin eingerichtet, eine zweite Ladungsverschiebung mittels einer Differenz des dritten Ladungszustands und des ersten Ladungszustands zu bestimmen. Außerdem ist die Recheneinheit eingerichtet, einen Kapazitätsverlust aus der Differenz der ersten Ladungsverschiebung und der zweiten Ladungsverschiebung zu bestimmen und einen mittleren Kapazitätsverlust zu bestimmen, wenn der Kapazitätsverlust im Wesentlichen konstant ist. Weiterhin ist die Recheneinheit eingerichtet, den mittleren Kapazitätsverlust zu ermitteln.

Das erfindungsgemäße Computerprogrammprodukt ist direkt in einen Speicher einer programmierbaren Recheneinheit ladbar. Es umfasst Programmcode-Mittel, um das erfindungsgemäße Verfahren auszuführen, wenn das Computerprogrammprodukt in der Recheneinheit ausgeführt wird.

Der mittlere Kapazitätsverlust beschreibt die Alterungsgeschwindigkeit für einen gewählten Lastzyklus in der Einheit Kapazitätsverlust pro Zyklus. Vorteilhaft ist es mit dem erfindungsgemäßen Verfahren möglich, eine quantitative Auswertung der Messdaten der Hoch-Präzisions-Coulometrie-Vorrichtung hinsichtlich der Alterungsgeschwindigkeit der Batterie vorzunehmen. Die quantitative Auswertung ist möglich, da basierend auf dem Ermitteln des mittleren Kapazitätsverlusts absolute Werte für die Kapazität ermittelt werden können.

Weiterhin ist es mit dem erfindungsgemäßen Verfahren vorteilhaft möglich, nicht-symmetrische Lade- und Entladezyklen, sowie hohe Stromstärken für einen Lastzyklus zu verwenden. In anderen Worten kann es sich um einen beliebigen Lastzyklus, insbesondere um ein konstantes Stromprofil, ein konstantes Leistungsprofil, ein transientes Stromprofil oder ein transientes Leistungsprofil handeln. Der Lastzyklus kann auch Pausen aufweisen, in denen kein Strom fließt, z. B. an den Umkehrpunkten, definiert durch die Spannungsgrenzen. Der Lastzyklus wird lediglich periodisch durchlaufen und trifft auf zwei feste Spannungsgrenzen. Die Auswahl der Spannungsgrenzen definiert einen bestimmten Arbeitspunkt, charakterisiert durch einen mittleren Ladezustand (SOC) und eine Zyklentiefe (DOD).

Weiterhin ist es vorteilhaft möglich, mit dem erfindungsgemäßen Verfahren Alterungszustände in kurzer Zeit zu bestimmen. Vorteilhaft kann die Produktentwicklung des elektrochemischen Energiespeichers oder dessen Anwendung somit beschleunigt werden. Vorteilhaft senkt dies die Kosten der Produktentwicklung. Weiterhin verringert sich die Auslastung des Testequipments, was die Entwicklung effizienter macht.

Die ermittelten Kapazitätsverluste werde als nahezu konstant angesehen, wenn eine Steigung einer Tangente, welche an den Verlauf der Kapazitätsverluste angepasst wurden, betragsmäßig einen Wert kleiner als 10 % des Mittelwertes der Steigungen der letzten 10 % der gemessenen Kapazitätsverluste aufweisen. Alternativ werden die Kapazitätsverluste als nahezu oder im Wesentlichen konstant angesehen, wenn eine absolute Änderung wenigstens zweier aufeinanderfolgender Kapazitätsverluste (dKap) insbesondere weniger als 5 % beträgt.

Vorteilhaft erfolgt die Bestimmung des mittleren Kapazitätsverlusts computergestützt durch einen gleitenden linearen Fit über die Werte des Kapazitätsverlusts und das Auffinden der kleinsten Steigungen in den so erzeugten Geradengleichungen. Ausgehend von einem Fit über alle Kapazitätsverluste wird der Datensatz, welcher die ermittelten Kapazitätsverluste umfasst, laufend gekürzt und eine neue Gerade gefittet. Der Fit wird bis zu einer bestimmten minimalen Restlänge des Datensatzes, also der Kapazitätsverluste, durchgeführt. Im Anschluss werden die Geradengleichungen nach den Werten ihrer Steigungen der Größe nach ansteigend sortiert. Die Messung kann dann als gültig angesehen werden, wenn wenigstens zwei der Steigungen betragsmäßig einen Wert kleiner als 10 % des Mittelwertes der letzten 10 % der Kapazitätsverluste aufweisen. Beträgt beispielsweise der Mittelwert der letzten zwanzig Kapazitätsverluste, insbesondere bei einer Messung von wenigstens 200 Kapazitätsverlusten, 5 mAh/Lastzyklus, dann sollte sie Steigung der beiden besten angepassten Tangenten ("Fits") weniger als 0,05 mAh/Lastzyklus aufweisen.

Es wurde insbesondere im Rahmen der Erfindung erkannt, dass Kapazitätsverluste erst nach einer Einschwingphase des Lastzyklus zum Ermitteln der Restkapazität herangezogen werden dürfen. Kapazitätsverluste, welche zu Beginn der Messungen, also während des Einschwingvorgangs, ermittelt werden sind fehlerbehaftet und sollten somit nicht in die Ermittlung des mittleren Kapazitätsverlusts einbezogen werden. Es hat sich herausgestellt, dass diese Einschwingphase beendet ist, wenn wenigstens zwei der in einem Fitting an den Kapazitätsverlust angelegte Geraden Steigungen von betragsmäßig kleiner als 10 % des Mittelwertes der letzten 10 % der gemessenen Kapazitätsverluste aufweisen. Alternativ gelten die Kapazitätsverluste als nahezu konstant, wenn zwei aufeinanderfolgende Kapazitätsverluste und/oder ein gleitender Mittelwert über wenigstens 20 Kapazitätsverluste eine Änderung von weniger als 5% als Kapazitätsverlust aufweisen. Vorteilhaft gewährleistet dieses Vorgehen, dass die Ermittlung der Restkapazität basierend auf dem Kapazitätsverlust schnell und dennoch zuverlässig durchführbar ist.

In einer weiteren vorteilhaften Ausgestaltung und Weiterbildung der Erfindung herrscht in jedem aufeinanderfolgenden Lastzyklus innerhalb einer Bestimmung des Kapazitätsverlusts eine konstante Temperatur. In anderen Worten bedeutet das, dass die Temperatur bei zwei aufeinanderfolgenden Bestimmungen des Kapazitätsverlusts unterschiedlich sein kann. Die Temperatur während eines Lastzyklus ist aber konstant. Vorteilhaft können für das Bestimmen des mittleren Kapazitätsverlusts also Lastzyklen kombiniert werden, welche jeweils bei unterschiedlichen Temperaturen aufgenommen wurden, solange die Temperatur innerhalb eines Lastzyklus konstant geblieben ist.

In einer weiteren vorteilhaften Ausgestaltung und Weiterbildung der Erfindung wird die Batterie oder Batteriezelle in einer Temperierkammer betrieben. Die Batterie oder Batteriezelle ist in dieser Ausgestaltung in einer Temperierkammer angeordnet.

Insbesondere ermöglicht die Temperierkammer, eine ausreichend hohe Temperaturstabilität während eines Lastzyklus der Batterie zu gewährleisten. Alternativ ist es möglich die Temperatur des Batteriespeichers, welche den Lastzyklus durchläuft, mittels eines kontaktieren Temperaturreglers und/oder eines Kühlkreislauf zu stabilisieren. Vorteilhaft gewährleistet der Einsatz einer Temperierung, dass die Temperatur während einer Bestimmung des Kapazitätsverlusts konstant bleibt. Dies erhöht die Zuverlässigkeit der Bestimmung der Restkapazität des Batteriespeichers vorteilhaft.

Es ist vorteilhaft möglich, für das Messen eines Lastzyklus eine beliebige Temperatur des erlaubten Arbeitsbereichs einzusetzen. Vorteilhaft muss eine Bestimmung eines einzelnen Kapazitätsverlusts also nicht bei Standardbedingungen durchgeführt werden.

In einer weiteren vorteilhaften Ausgestaltung und Weiterbildung der Erfindung wird die untere Spannung aus einem ersten Spannungsbereich und die obere Spannung aus einem zweiten Spannungsbereich ausgewählt. Der zweite Spannungsbereich liegt zweckmäßigerweise bei höheren Spannungen als der erste Spannungsbereich. Besonders vorteilhaft können sowohl der erste Spannungsbereich als auch der zweite Spannungsbereich aus dem gesamten Arbeits-Spannungsbereich des Batteriespeichers gewählt werden. Es müssen in anderen Worten keine Vollzyklen durchgeführt werden. Es ist also möglich, den zugelassen Spannungsbereich des Batteriespeichers gemäß Produktblatt oder darüber hinaus einzusetzen. Vorteilhaft ermöglicht das Messen des Kapazitätsverlusts ohne das Durchführen von Vollzyklen, also einem vollständigen Laden und Entladen, eine kürzere Messdauer. Weiterhin wird der Batteriespeicher weniger stark durch die Messung belastet, was vorteilhaft eine schnelle Alterung verhindert.

In einer weiteren vorteilhaften Ausgestaltung der Erfindung werden wenigstens zwei Kapazitätsverluste ausgewählt und für das Ermitteln der Restkapazität gemittelt und mit der Anzahl der ausgewählten Lastzyklen multipliziert.

Besonders vorteilhaft wird der gleitende Mittelwert für die Bestimmung des mittleren Kapazitätsverlusts aus wenigstens 20 Kapazitätsverlusten ermittelt.

In einer weiteren vorteilhaften Ausgestaltung und Weiterbildung der Erfindung wird eine Restkapazität des Batteriespeichers basierend auf der Differenz einer Startkapazität und des mittleren Kapazitätsverlusts ermittelt. Vorteilhaft kann diese Restkapazität mit einer Referenz-Restkapazität verglichen werden. Dies ermöglicht eine Validierung der gewählten Eigenschaften des Lastprofils und der Auswertung. Weiterhin stellt die Restkapazität einen Wert dar, basierend auf welchem verschiedene Batteriespeicher direkt miteinander vergleichbar sind. So können zwei Batteriespeicher unterschiedlicher Hersteller mit demselben Lastprofil betrieben werden. Anhand der ermittelten Restkapazität kann auf das Alterungsverhalten der unterschiedlichen Batteriespeicher geschlossen werden und somit eine Auswahl für eine vorgegebene Anwendung, welche das Lastprofil abbildet, getroffen werden.

In einer weiteren vorteilhaften Ausgestaltung und Weiterbildung der Erfindung wird die Restkapazität basierend auf wenigstens zwei mittleren Kapazitätsverlusten bestimmt. Besonders vorteilhat werden für die Ermittlung der mittleren Kapazitätsverluste unterschiedliche Bedingungen im Lastzyklus aus einem Lastkollektiv ausgewählt. In anderen Worten heißt das, dass das erfindungsgemäße Verfahren mit einem ersten Lastprofil und mit einem zweiten Lastprofil, welches sich vom ersten Lastprofil unterscheidet, durchgeführt wird. Für das erste und zweite Lastprofil wird jeweils ein erster und ein zweiter mittlerer Kapazitätsverlust bestimmt. Basierend auf den wenigstens zwei mittleren Kapazitätsverlusten wird dann eine Restkapazität bestimmt. Vorteilhaft kann diese Bestimmung für zwei unterschiedliche Batteriespeicher, insbesondere unterschiedlicher Spezifikationen und/oder unterschiedlicher Hersteller, erfolgen. Für einen geplanten Einsatz, der der Kombination der beiden Lastprofile ähnlich ist oder gleicht, kann somit vorteilhaft der optimale Batteriespeiche ermittelt werden.

Als Lastkollektiv wird ein Kollektiv angesehen, welches wenigstens zwei unterschiedliche Lastprofile aufweist.

In einer weiteren vorteilhaften Ausgestaltung und Weiterbildung der Erfindung werden die Bedingungen der Lastzyklen des Lastkollektivs in Abhängigkeit eines vorgegebenen Batteriebetriebs ausgewählt. Die Ermittlung der Restkapazität stellt dann eine Vorhersage der Restkapazität für den Batteriebetrieb dar. Alternative kann die Restkapazität in eine Vorhersage eines Alterungsverhaltens des Batteriespeichers für den Batteriebetriebs eingehen. Besonders vorteilhaft wird das Lastkollektiv derart definiert, dass es die Beanspruchung des Batteriespeichers in dem konkreten Batteriebestrieb, z.B. dem Einsatz in einem Elektrofahrzeug oder als Heimspeicher, widergibt.

Wird für das Ermitteln der Restkapazität ein Mittelwert verwendet, wird die Zuverlässigkeit der Bestimmung der Restkapazität vorteilhaft erhöht.

In einer weiteren vorteilhaften Ausgestaltung und Weiterbildung der Erfindung wird das Verfahren zum Ermitteln eines mittleren Kapazitätsverlusts computergestützt in einer Recheneinheit ausgeführt. Vorteilhaft kann das Messverfahren somit automatisiert werden, was das Auswerten beschleunigt. Vorteilhaft kann die Produktentwicklung des elektrochemischen Energiespeichers oder dessen Anwendung somit beschleunigt werden. Vorteilhaft senkt dies die Kosten der Produktentwicklung. Weiterhin verringert sich die Auslastung des Testequipments, was die Entwicklung effizienter macht.

In einer weiteren vorteilhaften Ausgestaltung und Weiterbildung der Erfindung ist die Recheneinheit eingerichtet, die Anzahl der Lastzyklen basierend auf der Auswahl der Kapazitätsverluste zu bestimmen. In anderen Worten kann die Recheneinheit den mittleren Kapazitätsverlust auch bestimmen, wenn ein Mittelwert über wenigstens zwei Kapazitätsverluste gebildet wird.

In einer weiteren vorteilhaften Ausgestaltung und Weiterbildung der Erfindung ist die Recheneinheit eingerichtet, während die Messung des Lastzyklus erfolgt, zu ermitteln, ob bereits ein nahezu konstanter Wert des Kapazitätsverlustes erreicht ist und in Abhängigkeit des Ergebnisses der Auswertung einen weiteren Lastzyklus des Batteriespeichers anzustoßen. Vorteilhaft ist es möglich, das Ermitteln der Restkapazität automatisiert durchzuführen.

Weitere Merkmale, Eigenschaften und Vorteile der vorliegenden Erfindung ergeben sich aus der nachfolgenden Beschreibung unter Bezugnahme auf die beiliegenden Figuren. Darin zeigen schematisch:

Figur 1 eine Vorrichtung Bestimmen des mittleren Kapazitätsverlusts und einer Restkapazität mit einer Hoch-Präzisions-Coulometrie-Vorrichtung;

Figur 2 ein Spannungs-Zeit-Diagramm eines Lastzyklus;

Figur 3 ein Spannungs-Ladungs-Diagramm eines Lastzyklus;

Figur 4 ein Kapazitätsverlust pro Zyklus - Zyklusanzahl-Diagramm von wenigstens 200 Lastzyklen;

Figur 5 ein Restkapazität - Zyklusanzahl -Diagramm von wenigstens 200 Lastzyklen;

Figur 6 ein Verfahrensschema zum Bestimmen des mittleren Kapazitätsverlusts der Restkapazität des Batteriespeichers.

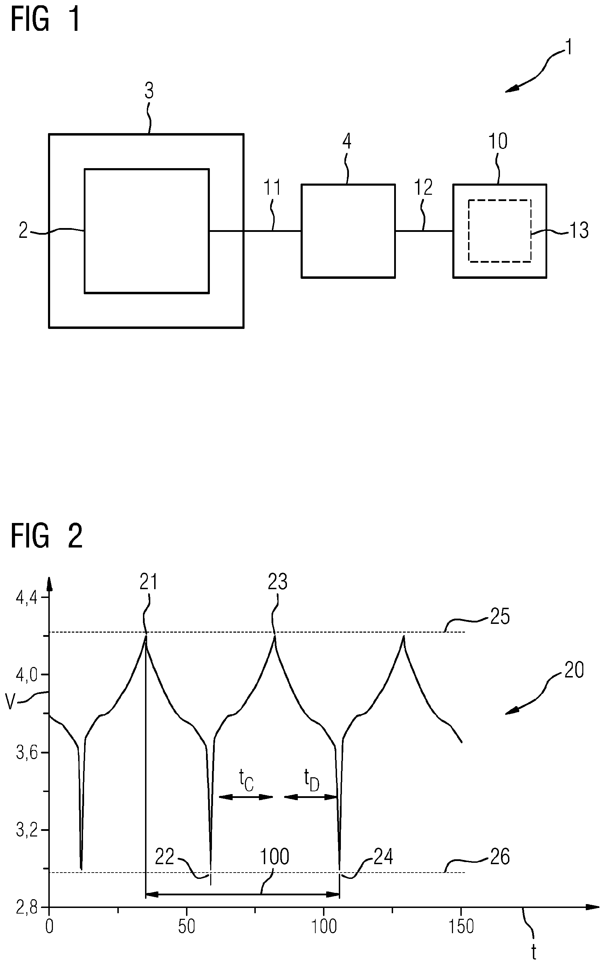

Figur 1 zeigt eine Vorrichtung zum Bestimmen des mittleren Kapazitätsverlusts und der Restkapazität mit einer Hoch-Präzisions-Coulometrie-Vorrichtung 1. Die Vorrichtung 1 umfasst einen Batteriespeicher 2, wobei der Batteriespeicher wenigstens eine Batteriezelle aufweist. Der Batteriespeicher ist in einer Temperierkammer 3 angeordnet ist. Der Batteriespeicher 2 ist über ein Stromkabel 11 mit einer Hoch-Präzisions-Coulometrie-Vorrichtung 4 verbunden. Die Hochpräzisions-Coulometrie-Vorrichtung 4 ist wiederum mit einer Recheneinheit 10 über ein Datenkabel 12 verbunden. Die Hochpräzisions-Coulometrie-Vorrichtung 4 nimmt mit sehr großer Genauigkeit ein Ladungs-Zeit-Diagramm des Batteriespeichers 2 auf. Der Batteriespeicher 2 wird dabei mit einem periodischen Lastzyklus 100 betrieben.

Figur 2 zeigt ein Spannungs-Zeit-Diagramm, welches die Hoch-präzisions-Coulometrie-Vorrichtung 4 während eines periodischen Lastzyklus 100 des Batteriespeichers 2 aufgezeichnet hat. Ein Lastzyklus 100 umfasst ein Entladen von einem ersten Ladezustand 21 zu einem zweiten Ladezustand 22, wobei der erste Ladezustand 21 bei einer oberen Spannung 25 liegt und der zweite Ladezustand 22 bei einer unteren Spannung 26 liegt. Anschließend wird in dem Lastzyklus 100 der Batteriespeicher 2 von dem zweiten Ladezustand 22 zu einem dritten Ladezustand 23 geladen. Als nächster Schritt wird in dem Lastzyklus 100 der dritte Ladezustand 23 bis zu einem vierten Ladezustand 24 entladen. In jedem einzelnen Lade-/Entladeschritt wird eine obere Spannung 25 und eine untere Spannung 26 als Spannungsgrenzen eingehalten. Das Laden dauert den Ladezeitraum $t_C$. Das Entladen dauert den Entladezeitraum $t_D$.

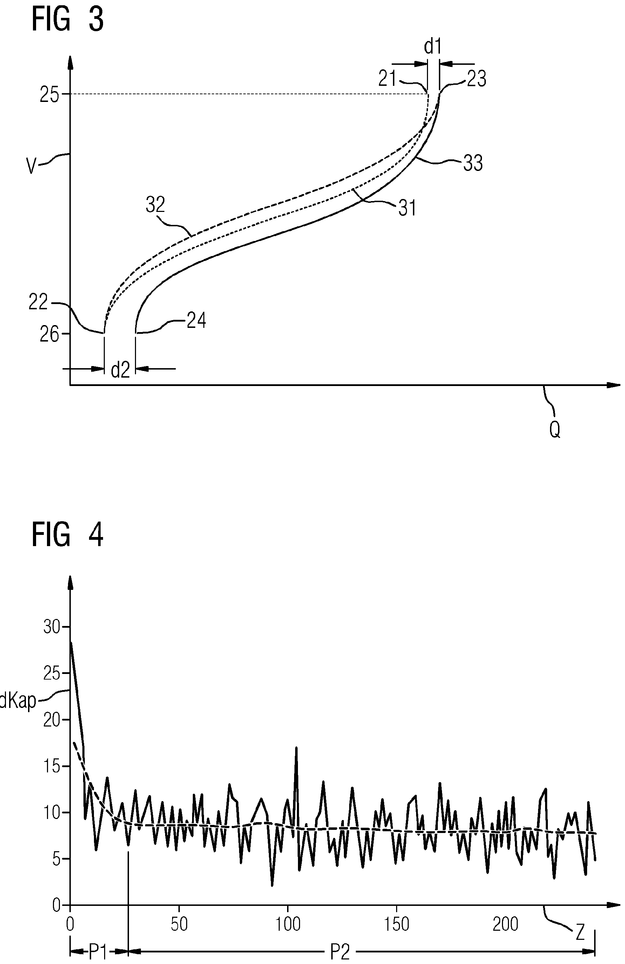

Basierend auf der in Figur 2 gezeigten Messung kann nun, wie in Figur 3 gezeigt, ermittelt werden, welche kumulative Ladungsmenge in den einzelnen Lade- und Entlade-Schritten geflossen ist. Figur 3 zeigt ein Diagramm, in welchem die Spannung des Batteriespeichers über der kumulativen Ladungsmenge Q aufgetragen ist. Der Lastzyklus 100 beginnt wiederum bei dem ersten Ladezustand 21. Der Batteriespeicher 2 wird bis zu dem zweiten Ladezustand 22 bei dem ersten Entladen 31 entladen. Dabei wird eine erste Ladungsmenge Q1 aus dem Batteriespeicher 2 entnommen. Die erste Ladungsmenge Q1 kann über Gleichung 1 berechnet werden, wobei I den Stromfluss und $t_D$ den Entladezeitraum bezeichnet:

$$Q1 = \int I \, dt_D \qquad\qquad \text{Gleichung 1}$$

Innerhalb des Lastzyklus 100 wird der Batteriespeicher 2 anschließend von dem zweiten Ladezustand 22 zu dem dritten Ladezustand 23 mittels eines ersten Ladens 32 geladen. Es wird eine zweite Ladungsmenge Q2 in den Batteriespeicher 2 geladen. Q2 kann mittels der Gleichung 2 berechnet werden:

$$Q2 = \int I \, dt_c \qquad\qquad\qquad \text{Gleichung 2}$$

Innerhalb des Lastzyklus 100 wird der Batteriespeicher 2 anschließend von dem dritten Ladezustand 23 zu dem vierten Ladezustand 24 mittels eines zweiten Entladens 33 entladen. Die entnommene Ladungsmenge Q3 kann wiederum analog zu Gleichung 1 aus dem Zeitraum des Entladens dem dazugehörigen Stromfluss berechnet werden.

Nun ist es möglich zwischen dem ersten Ladezustand 21 und dem dritten Ladezustand 23 eine erste Ladungsverschiebung d1 zu ermitteln. Weiterhin kann eine zweite Ladungsverschiebung d2 zwischen dem zweiten Ladezustand 22 und dem vierten Ladezustand 24 ermittelt werden. Aus der Differenz der ersten Ladungsverschiebung d1 und der zweiten Ladungsverschiebung d2 kann nun ein Kapazitätsverlust dKap für den Lastzyklus 100 mittels Gleichung 3 ermittelt werden.

$$dKap = d2 - d1 \qquad\qquad\qquad \text{Gleichung 3}$$

In Figur 4 ist nun der Kapazitätsverlust pro Lastzyklus für 250 Lastzyklen dargestellt. Dabei befinden sich auf der x-Achse die Lastzykluszahl Z, also die laufende Anzahl des jeweiligen Lastzyklus 100, auf der y-Achse befindet sich der Kapazitätsverlust dKap pro Lastzyklus 100. Figur 4 verdeutlicht, dass zunächst eine Einschwingphase P1 während der nacheinander folgenden Lastzyklen 100 auftritt. Die Länge der Einschwingphase P1 ist abhängig vom Arbeitspunkt und der Vorgeschichte des Batteriespeichers oder der Batteriezelle. Die Einschwingphase P1 kann vorteilhaft z. B. dadurch verkürzt werden, dass die Vermessung des nachfolgenden Arbeitspunkts beim gleichen mittleren Ladezustand (SOC) wie die vorhergehenden Messung durchgeführt wird.

Die Bestimmung des mittleren Kapazitätsverlusts $dKap_{mittel}$ als Messwert des Verfahrens erfolgt durch einen gleitenden linearen Fit über die Werte des Kapazitätsverlusts dKap und das Bestimmen der kleinsten Steigungen in den so erzeugten Geradengleichungen. Ausgehend von einem Fit über alle Werte des Kapazitätsverlusts dKap, also z. B. Wert 1 bis Wert 250 wird der Datensatz laufend gekürzt und eine neue Gerade erzeugt (angefittet) (2 bis 250, 3 bis 250, usw.). Der Fit wird durchgeführt bis zu einer bestimmten minimalen Restlänge des Datensatzes, z. B. 10 % der Gesamtlänge. Im Anschluss werden die Geradengleichungen insbesondere nach den Werten ihrer Steigungen der Größe nach ansteigend sortiert. Die Messung kann dann als gültig angesehen werden, wenn wenigstens zwei der Steigungen betragsmäßig einen Wert kleiner als 10 % des Mittelwertes der letzten 10 % der Kapazitätsverluste dKap aufweisen. Beträgt beispielsweise der Mittelwert der letzten zwanzig Kapazitätsverluste, insbesondere bei einer Messung von wenigstens 200 Kapazitätsverlusten, 5 mAh/Lastzyklus, dann sollte sie Steigung der beiden besten angepassten Tangenten ("Fits") weniger als 0,05 mAh/Lastzyklus aufweisen.

Ansonsten ist die Messung, insbesondere mit einer größeren Anzahl an Stützpunkten, zu wiederholen, weil kein ausreichend stationärer Zustand des Systems erreicht wurde. Aus der Sortierung wird eine bestimmte Anzahl, z. B. abgerundet 3 % der Gesamtlänge des Datensatzes, bzw. eine minimale Anzahl von zwei Messerwerten, ausgewählt und die entsprechenden Startindizes der gefitteten Geraden ermittelt. Für jeden der so ermittelten Abschnitte wird ein gemittelter Kapazitätsverlust als arithmetischer Mittelwert über die eingeschlossenen Kapazitätsverluste dKap angegeben. Der Wert des mittleren Kapazitätsverlusts $dKap_{Mittel}$ wird anschließend als Mittelwert über die gemittelten einzelnen Kapazitätsverluste bestimmt.

Ist noch kein ausreichend stationärer, also im Wesentlichen konstanter, Kapazitätsverlust erreicht, wird die Messung des Lastzyklus wiederholt. Aus der Sortierung wird dann wiederum eine bestimmte Anzahl, z. B. abgerundet 3 % der Gesamtlänge des Datensatzes, bzw. eine minimale Anzahl von zwei, ausgewählt und die entsprechenden Startindizes der gefitteten Geraden ermittelt. Für jeden der so ermittelten Abschnitte wird der mittlere Kapazitätsverlust $dKap_{Mittel}$ als arithmetischer Mittelwert über die eingeschlossenen Kapazitätsverluste angegeben. Der Wert des mittleren Kapazitätsverlusts $dKap_{Mittel}$ kann aber auch als Mittelwert über die arithmetisch gemittelten Kapazitätsverluste ermittelt werden.

Figur 4 verdeutlicht auch, dass sich an die Einschwingphase P1 eine Ermittlungsphase P2 anschließt. Diese Phasen können sich während der Auswertung der Kapazitätsverluste dKap verschieben.

Basierend auf dem mittleren Kapazitätsverlust dKap ist es nun möglich eine Restkapazität CR zu bestimmen und somit für das verwendete Lastprofil ein Alterungsverhalten des untersuchten Batteriespeichers bei den Bedingungen des Lastzyklus eine Vorhersage zu treffen. Der mittlere Kapazitätsverlusts $dKap_{Mittel}$ wird vorteilhaft zum Ermitteln der Restkapazität verwendet. Der mittlere Kapazitätsverlust $dKap_{Mittel}$ wird mit der Anzahl der in die Bewertung eingeflossenen Lastzyklen multipliziert und von der Startkapazität CS abgezogen. Daraus ergibt sich die Restkapazität CR, wie in Gleichung 4 dargestellt.

$$CR = CS - Z \cdot dKap_{Mittel} \qquad\qquad\qquad \text{Gleichung 4}$$

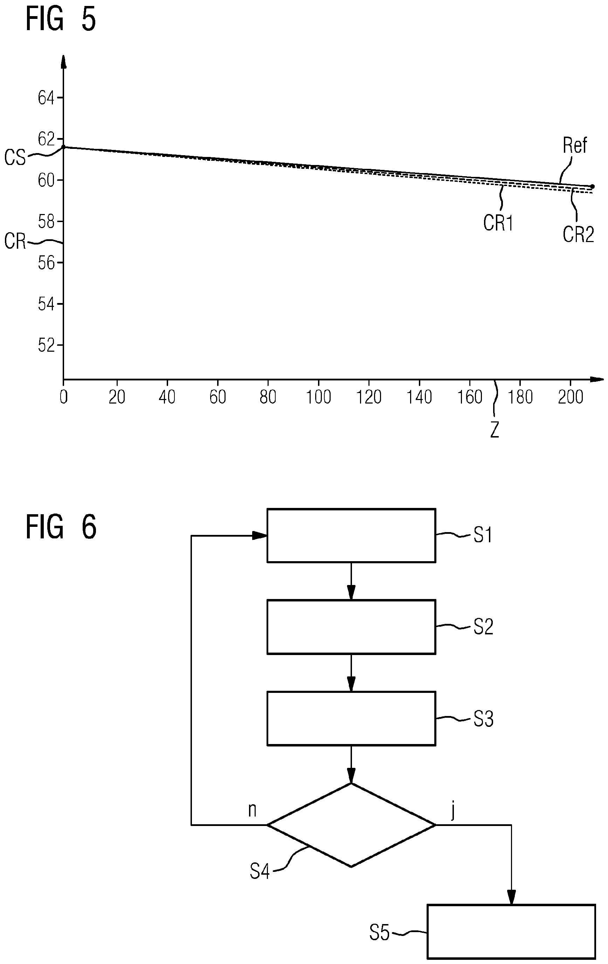

Figur 5 zeigt ein Diagramm der berechneten Restkapazität CR über der Lastzykluszahl Z. Vor dem ersten Lastzyklus kann aus diesem Diagramm auch die Startkapazität CS abgelesen werden. Das in Figur 5 gezeigte Diagramm zeigt die Restkapazität CR, welche auf drei unterschiedlichen Datensätzen der Kapazitätsverluste dKap basiert. In der ersten ermittelten Restkapazität CR 1 wurde eine erste Zyklen- Anzahl der Lastzyklen-Nummern 42 bis 241 ausgewählt. In der zweiten ermittelten Restkapazität CR2 wurde eine zweite Zyklen- Anzahl der Lastzyklen-Nummern 162 bis 241 in die Ermittlung einbezogen. Die Referenzkapazität Ref und die Startkapazität CS wurden mittels eines Standard-Kapazitätstests nach Vorgabe des Zellherstellers ermittelt. Der Vergleich der ermittelten Restkapazitäten CR1, CR2 und Ref zeigt, dass die erste Restkapazität CR1 und die zweite Restkapazität CR2 eine hohe Übereinstimmung zur Referenz-Restkapazität Ref zeigen. Die Qualität der Bestimmung der Restkapazität steigt mit fortlaufender Verkürzung der in die Bestimmung von dKap$_{Mittel}$ einbezogen Stützpunkte vorteilhaft.

Aus Figur 5 wird deutlich, dass die Restkapazität zuverlässig basierend auf den Lastzyklen und deren Auswertung ermittelt werden kann. Es kann also basierend auf Hochpräzisions-Coulemtrie-Messungen eine quantitative Bestimmung der Kapazität des Batteriespeichers 2 für die eingesetzten Lastprofile erfolgen. Durch Auswahl der Lastprofile aus einem Lastprofilkollektiv für einen definierten Batteriebetrieb kann diese Bestimmung als Vorhersage der (Rest-)Kapazität des Batteriespeichers für den definierten Batteriebetrieb angesehen werden. Dies ermöglicht vorteilhaft insbesondere die Auswahl eines Batteriespeichers für eine definierte Anwendung des Batteriespeichers, insbesondere in einem Elektrofahrzeug, einem Elektrozug oder einem Heimspeicher.

Weiterhin kann die Messmethode vorteilhaft auch für unsymmetrische Lade- oder Entladeströme und bei beliebig hohen Stromstärken angewendet werden. Ein weiterer Vorteil der Methode ist es, dass die Methode unabhängig von Einflüssen, insbesondere wie dem des Anodenüberhang, ist. Ein Lastzyklus 100 muss weiterhin vorteilhaft kein Vollzyklus des Batteriespeichers 2 darstellen.

Figur 6 zeigt ein Verfahrensschema des Verfahrens zum Bestimmen des mittleren Kapazitätsverlusts dKap$_{Mittel}$ und der Restkapazität CR eines Batteriespeichers 2. In einem ersten Schritt S1 erfolgt das Messen von wenigestens zehn Lastzyklen des Batteriespeichers mittels einer Hoch-Präzisions-Coulometrie-Vorrichtung. Ein Lastzyklus umfasst dabei ein erstes Entladen, ein erstes Laden und ein zweites Entladen. In einem zweiten Schritt S2 werden die Ladungsverschiebungen bestimmt. In einem dritten Schritt S3 wird, basierend auf den Ladungsverschiebungen, ein Kapazitätsverlust bestimmt. In einem vierten Schritt S4 erfolgt das Überprüfen des Kapazitätsverlusts auf Konstanz. Werden die wenigstens zwei Kapazitätsverluste nicht als konstant angesehen, so wird ein weiterer Lastzyklus beginnend mit dem Schritt S1 gestartet. Werden die wenigstens zwei Kapazitätsverluste als konstant angesehen, wird in einem fünften Schritt S5 der mittlere Kapazitätsverlust dKap$_{Mittel}$ für den vermessenen Arbeitspunkt, also das definierte Lastprofil angegeben. Das Messergebnis kann dann, insbesondere zusammen mit den Ergebnissen für weitere Arbeitspunkte, bzw. Lastprofile, für z. B. die Auslegung oder Modellierung eines Batteriespeichers verwendet werden.

Obwohl die Erfindung im Detail durch das bevorzugte Ausführungsbeispiel näher illustriert und beschrieben wurde, ist die Erfindung nicht durch die offenbarten Beispiele eingeschränkt. Variationen hiervon können vom Fachmann abgeleitet werden, ohne den Schutzumfang der Erfindung, wie er durch die nachfolgenden Patentansprüche definiert wird, zu verlassen.

Bezugszeichenliste

| | |
|---|---|
| 1 | Vorrichtung zur Vorhersage der Restkapazität |
| 2 | Batteriespeicher |
| 3 | Temperierkammer |
| 4 | Hoch-Präzisions-Coulometrie-Vorrichtung |
| 10 | Recheneinheit |
| 11 | Stromkabel |
| 12 | Datenkabel |
| 13 | Computerprogrammprodukt |
| 21 | erster Ladezustand |
| 22 | zweiter Ladezustand |
| 23 | dritter Ladezustand |
| 24 | vierter Ladezustand |
| 25 | obere Spannung |
| 26 | untere Spannung |
| 31 | erstes Entladen |
| 32 | erstes Laden |
| 33 | zweites Entladen |

100     Lastzyklus

t       Zeit
$t_C$     Ladezeitraum
$t_D$     Entladezeitraum
V       Spannung
Q       Ladung
CR      Restkapazität
CS      Startkapazität
d1      erste Ladungsverschiebung
d2      zweite Ladungsverschiebung
Z       Ladezykluszahl
dKap    Kapazitätsverlust pro Lastzyklus
P1      Einschwingphase
P2      Ermittlungsphase
S1      Messen eines Lastzyklus
S2      Bestimmen einer ersten und zweiten Ladungsverschiebung
S3      Bestimmen eines Kapazitätsverlusts
S4      Überprüfen wenigstens zweier Kapazitätsverluste auf Konstanz
S5      Ermitteln des mittleren Kapazitätsverlusts und der Restkapazität


**Patentansprüche**

1. Verfahren zum Ermitteln wenigstens eines mittleren Kapazitätsverlusts eines Batteriespeichers (2) umfassend mehrere Schritte:

a) Messen wenigstens zweier Lastzyklen (100) des Batteriespeichers (2) mittels einer Hoch-Präzisions-Coulometrie-Vorrichtung (4), wobei ein Lastzyklus (100) ein erstes Entladen umfasst, bei dem eine erste Ladungsmenge (Q1) von einem ersten Ladungszustand (21) zu einem zweiten Ladungszustand (22) gemessen wird, ein sich anschließendes erstes Laden, bei dem eine zweite Ladungsmenge (Q2) von dem zweiten Ladungszustand (22) zu einem dritten Ladungszustand (23) gemessen wird und ein zweites Entladen, bei dem eine dritte Ladungsmenge (Q3) von dem dritten Ladungszustand (23) zu einem vierten Ladungszustand (24) gemessen wird, wobei das Laden und Entladen des Lastzyklus (100) zwischen einer unteren Spannung (26) und einer oberen Spannung (25) des Batteriespeichers (2) erfolgt,
b) Bestimmen einer ersten Ladungsverschiebung (d1) mittels einer Differenz des vierten Ladungszustands (24) und des zweiten Ladungszustands (22) und Bestimmen einer zweiten Ladungsverschiebung (d2) mittels einer Differenz des dritten Ladungszustands (23) und des ersten Ladungszustands (21),
c) Bestimmen eines Kapazitätsverlusts (dKap) aus der Differenz der ersten Ladungsverschiebung (d1) und der zweiten Ladungsverschiebung (d2),

- Durchführen der Schritte a) bis c) bis der Kapazitätsverlust (dKap) in wenigstens zwei aufeinanderfolgenden Lastzyklen (100) nahezu konstant ist,
- Ermitteln eines mittleren Kapazitätsverlusts ($dKap_{mittel}$) basierend auf wenigstens zwei Kapazitätsverlusten (dKap).

2. Verfahren nach einem der Ansprüche 1 oder 2, wobei in jedem aufeinanderfolgenden Lastzyklus (100) innerhalb des Lastzyklus eine konstante Temperatur herrscht.

3. Verfahren nach Anspruch 3, wobei die Hoch-Präzisions-Coulometrie-Vorrichtung (4) in einer Temperierkammer (3), mit einem konduktiven Temperaturregler und/oder mit einer Kühlvorrichtung temperiert wird.

4. Verfahren nach einem der vorhergehenden Ansprüche, wobei die untere Spannung (26) aus einem ersten Spannungsbereich und die obere Spannung (25) aus einem zweiten Spannungsbereich des Batteriespeichers (2) ausgewählt werden.

5. Verfahren nach Anspruch 5, wobei der erste Spannungsbereich und der zweite Spannungsbereich aus einem gesamten Arbeits-Spannungsbereich des Batteriespeichers (2) ausgewählt werden.

6. Verfahren nach einem der vorhergehenden Ansprüche, wobei eine Restkapazität (CR) des Batteriespeichers aus der Differenz einer Startkapazität (CS) und des mittleren Kapazitätsverlusts (dKap$_{mittel}$) ermittelt wird.

7. Verfahren nach Anspruch 6, wobei die Restkapazität basierend auf wenigstens zwei mittleren Kapazitätsverlusten (dKap$_{mittel}$) bestimmt wird,

8. Verfahren nach Anspruch 7, wobei für das Ermitteln der wenigstens zwei mittleren Kapazitätsverluste (dKap$_{mittel}$) für jeden mittleren Kapazitätsverlust unterschiedliche Bedingungen im Lastzyklus aus einem Lastkollektiv verwendet werden.

9. Verfahren nach Anspruch 8, wobei die Bedingungen der Lastzyklen des Lastkollektives in Abhängigkeit eines vorgegebenen Batteriebetriebs ausgewählt werden und die Ermittlung der Restkapazität (CR) eine Vorhersage der Restkapazität (CR) für den Batteriebetrieb darstellt oder die Restkapazität (CR) in eine Vorhersage eines Alterungsverhaltens des Batteriespeichers (2) für den Batteriebetrieb eingeht.

10. Verfahren nach einem der vorhergehenden Ansprüche, wobei das Verfahren computergestützt in einer Recheneinheit (10) erfolgt.

11. Vorrichtung (1) zum Durchführen eines Verfahrens nach einem der Ansprüche 1 bis 10, umfassend:

   - eine Hoch-Präzisions-Coulometrie-Vorrichtung (4), wobei diese eingerichtet ist, einen Lastzyklus (100) des Batteriespeichers (2) messtechnisch zu erfassen, wobei der Lastzyklus (100) ein erstes Entladen umfasst, bei dem eine erste Ladungsmenge (Q1) von einem ersten Ladungszustand (21) zu einem zweiten Ladungszustand (22) gemessen wird, ein sich anschließendes erstes Laden, bei dem eine zweite Ladungsmenge (Q2) von dem zweiten Ladungszustand (22) zu einem dritten Ladungszustand (23) gemessen wird und ein zweites Entladen, bei dem eine dritte Ladungsmenge (Q3) von dem dritten Ladungszustand (23) zu einem vierten Ladungszustand (24) gemessen wird, wobei das Laden und Entladen des Lastzyklus (100) zwischen einer unteren Spannung (26) und einer oberen Spannung (25) des Batteriespeichers (2) erfolgt,
   - eine Recheneinheit (10) eingerichtet zum Bestimmen einer ersten Ladungsverschiebung (d1) mittels einer Differenz des vierten Ladungszustands (24) und des zweiten Ladungszustands (22) und Bestimmen einer zweiten Ladungsverschiebung (d2) mittels einer Differenz des dritten Ladungszustands (23) und des ersten Ladungszustands Lauf 21), eingerichtet zum Bestimmen eines Kapazitätsverlusts (dKap) aus der Differenz der ersten Ladungsverschiebung (d1) und der zweiten Ladungsverschiebung (d2), eingerichtet zum Ermitteln eines mittleren Kapazitätsverlusts (dKap$_{mittel}$).

12. Vorrichtung (1) nach Anspruch 11, wobei die Recheneinheit (100) eingerichtet ist zum Ermitteln der Restkapazität (CR) aus der Differenz einer Startkapazität (CS) und wenigstens eines mittleren Kapazitätsverlusts (dKap$_{mittel}$).

13. Vorrichtung (1) nach Anspruch 11 oder 12, wobei die Recheneinheit (10) eingerichtet ist, die Anzahl (Z) der Lastzyklen (100) basierend auf den zur Ermittlung des mittleren Kapazitätsverlusts (dKap$_{mittel}$) herangezogenen Kapazitäts-verlusten (dKap) zu bestimmen.

14. Vorrichtung (1) nach einem der Ansprüche 11 bis 13, die Vorrichtung eine Temperierkammer (3) umfasst, welche geeignet ist, den Batteriespeicher anzuordnen.

15. Computerprogrammprodukt (13), welches direkt in einen Speicher einer programmierbaren Recheneinheit (10) ladbar ist, mit Programmcode-Mitteln, um ein Verfahren nach einem der Ansprüche 1 bis 10 auszuführen, wenn das Computerprogrammprodukt (13) in der Recheneinheit (10) ausgeführt wird.

**Claims**

1. Method for determining at least an average loss of capacity of a battery storage system (2) comprising several steps:

   (a) measuring at least two load cycles (100) of the battery storage system (2) by means of a high-precision coulometry device (4), where a load cycle (100) comprises a first discharge in which a first amount of charge (Q1) is measured from a first state of charge (21) to a second state of charge (22), a subsequent first charge in which a second amount of charge (Q2) is measured from the second state of charge (22) to a third state of charge (23) and a second discharge, in which a third amount of charge (Q3) is measured from the third state of charge (23) to a fourth state of charge (24), whereby the charging and discharging of the load cycle (100) takes place between a lower voltage (26) and an upper voltage (25) of the battery storage system (2),
(b) determining a first charge displacement (d1) by means of a difference between the fourth charge state (24) and the second charge state (22) and determining a second charge displacement (d2) by means of a difference between the third charge state (23) and the first charge state (21);
c) determining a capacity loss (dKap) from the difference between the first charge displacement (d1) and the second charge displacement (d2);

- Perform steps a) to c) until the capacity loss (dKap) is almost constant for at least two consecutive load cycles (100) ,
- Determine an average capacity loss (dKap$_{medium}$) based on at least two capacity losses (dKap).

**2.** A method according to one of claims 1 or 2, wherein there is a constant temperature in each successive load cycle (100) within the load cycle.

**3.** The method according to claim 3, wherein the high-precision coulometry device (4) in a temperature chamber (3), with a conductive temperature controller and/or a cooling device.

**4.** A method according to one of the preceding claims, wherein the lower voltage (26) is selected from a first voltage range and the upper voltage (25) from a second voltage range of the battery storage device (2).

**5.** The method according to claim 5, wherein the first voltage range and the second voltage range are selected from a total working voltage range of the battery storage device (2).

**6.** A method according to one of the preceding claims, wherein a residual capacity (CR) of the battery storage system is the difference between a starting capacity (CS) and the mean capacity loss (dKap$_{medium}$) is determined.

**7.** The method according to claim 6, wherein the residual capacity is calculated on the basis of at least two mean capacity losses (dKap$_{medium}$) is determined,

**8.** The method according to claim 7, wherein for the determination of at least two mean capacity losses (dKap$_{medium}$) different conditions in the load cycle from a load spectrum are used for each average capacity loss.

**9.** The method according to claim 8, wherein the conditions of the load cycles of the load spectrum are selected as a function of a given battery operation and the determination of the residual capacity (CR) is a prediction of the residual capacity (CR) for battery operation or the residual capacity (CR) is included in a prediction of an aging behavior of the battery storage system (2) for battery operation.

**10.** A method according to one of the preceding claims, wherein the method is computer-aided in a unit of account (10) .

**11.** Apparatus (1) for performing a method according to any of claims 1 to 10, comprising:

- a high-precision coulometry device (4) designed to measure a load cycle (100) of the battery storage system (2), where the load cycle (100) comprises a first discharge in which a first amount of charge (Q1) is measured from a first state of charge (21) to a second state of charge (22), a subsequent first charge in which a second amount of charge (Q2) is measured from the second state of charge (22) to a third state of charge (23) and a second discharge, in which a third amount of charge (Q3) is measured from the third state of charge (23) to a fourth state of charge (24), whereby the charging and discharging of the load cycle (100) takes place between a lower voltage (26) and an upper voltage (25) of the battery storage system (2),
- a computational unit (10) set up for determining a first charge displacement (d1) by means of a difference between the fourth charge state (24) and the second charge state (22) and determining a second charge displacement (d2) by means of a difference between the third charge state (23) and the first charge state run 21), set up for determining a capacity loss (dKap) from the difference between the first charge displacement (d1) and the second charge displacement (d2), set up to determine an average loss of capacity (dKap$_{medium}$).

**12.** Apparatus (1) according to claim 11, wherein the computing unit (100) is set up to determine the residual capacity (CR) from the difference between a starting capacity (CS) and at least an average loss of capacity (dKap$_{medium}$) .

**13.** Device (1) according to claim 11 or 12, wherein the computing unit (10) is set up, the number (Z) of load cycles (100) based on the quantities used to determine the mean capacity loss (dKap$_{medium}$) capacity losses (dKap).

**14.** Device (1) according to one of claims 11 to 13, the device comprises a temperature control chamber (3) which is suitable for arranging the battery storage.

**15.** A computer program product (13) which is directly loadable into a memory of a programmable computing unit (10), by means of program code to perform a method according to one of claims 1 to 10 when the computer program product (13) is executed in the computing unit (10).

**Revendications**

**1.** Méthode de détermination d'une perte de capacité au moins moyenne d'un système de stockage par batterie (2) comportant plusieurs étapes :

a) mesurant au moins deux cycles de charge (100) du système de stockage par batterie (2) au moyen d'un dispositif de coulométrie de haute précision (4), lorsqu'un cycle de charge (100) comprend une première décharge au cours de laquelle une première quantité de charge (Q1) est mesurée d'un premier état de charge (21) à un deuxième état de charge (22), une première charge subséquente au cours de laquelle une deuxième quantité de charge (Q2) est mesurée à partir du deuxième état de charge (22) à un troisième état de charge (23) et une deuxième décharge, dans lequel une troisième quantité de charge (Q3) est mesurée à partir du troisième état de charge (23) vers un quatrième état de charge (24), la charge et la décharge du cycle de charge (100) ayant lieu entre une tension inférieure (26) et une tension supérieure (25) du système de stockage par batterie (2),
b) la détermination d'un premier déplacement de charge (d1) au moyen d'une différence entre le quatrième état de charge (24) et le deuxième état de charge (22) et la détermination d'un deuxième déplacement de charge (d2) au moyen d'une différence entre le troisième état de charge (23) et le premier état de charge (21) ;
c) la détermination d'une perte de capacité (dKap) à partir de la différence entre le premier déplacement de charge (d1) et le deuxième déplacement de charge (d2) ;

- Effectuer les étapes a) à c) jusqu'à ce que la perte de capacité (dKap) soit presque constante pendant au moins deux cycles de charge consécutifs (100),
- Déterminer une perte de capacité moyenne (dKap$_{Douleur\ moyenne}$) sur la base d'au moins deux pertes de capacité (dKap).

**2.** Procédé selon l'une des revendications 1 ou 2, dans lequel il y a une température constante à chaque cycle de charge successif (100) dans le cycle de charge.

**3.** Procédé selon la revendication 3, dans lequel le dispositif de coulométrie de haute précision (4) dans une chambre thermique (3), avec un régulateur de température conducteur et/ou un dispositif de refroidissement.

**4.** Procédé conforme à l'une des revendications précédentes, dans lequel la tension inférieure (26) est sélectionnée dans une première plage de tension et la tension supérieure (25) dans une deuxième plage de tension du dispositif de stockage sur batterie (2).

**5.** Procédé selon la revendication 5, dans lequel la première plage de tension et la deuxième plage de tension sont sélectionnées à partir d'une plage de tension de fonctionnement totale du dispositif de stockage sur batterie (2).

**6.** Méthode selon l'une des revendications précédentes, dans laquelle une capacité résiduelle (CR) du système de stockage par batterie est la différence entre une capacité de démarrage (CS) et la perte de capacité moyenne (dKap$_{Douleur\ moyenne}$) est déterminé.

**7.** Procédé selon la revendication 6, dans lequel la capacité résiduelle est calculée sur la base d'au moins deux pertes de capacité moyennes (dKap$_{Douleur\ moyenne}$) est déterminé,

**8.** Procédé selon la revendication 7, dans lequel, pour la détermination d'au moins deux pertes de capacité moyennes (dKap$_{Douleur\ moyenne}$) différentes conditions du cycle de charge d'un spectre de charge sont utilisées pour chaque perte de capacité moyenne.

9. Procédé selon la revendication 8, dans lequel les conditions des cycles de charge du spectre de charge sont sélectionnées en fonction d'un fonctionnement donné sur batterie et où la détermination de la capacité résiduelle (CR) est une prédiction de la capacité résiduelle (CR) pour le fonctionnement sur batterie ou la capacité résiduelle (CR) est incluse dans une prédiction d'un comportement de vieillissement du système de stockage par batterie (2) pour le fonctionnement sur batterie.

10. Une méthode selon l'une des revendications précédentes, dans laquelle la méthode est assistée par ordinateur dans une unité de compte (10).

11. Appareil (1) pour l'exécution d'un procédé selon l'une quelconque des revendications 1 à 10, comprenant :

   - un appareil de coulométrie de haute précision (4) conçu pour mesurer un cycle de charge (100) du système de stockage par batterie (2), où le cycle de charge (100) comprend une première décharge dans laquelle une première quantité de charge (Q1) est mesurée d'un premier état de charge (21) à un deuxième état de charge (22), une première charge ultérieure dans laquelle une deuxième quantité de charge (Q2) est mesurée du deuxième état de charge (22) à un troisième état de charge (23) et une deuxième décharge, dans laquelle une troisième quantité de charge (Q3) est mesurée du troisième état de charge (23) à un quatrième état de charge (24), la charge et la décharge du cycle de charge (100) ayant lieu entre une tension inférieure (26) et une tension supérieure (25) du système de stockage par batterie (2),
   - une unité de calcul (10) mise en place pour déterminer un premier déplacement de charge (d1) au moyen d'une différence entre le quatrième état de charge (24) et le deuxième état de charge (22) et la détermination d'un deuxième déplacement de charge (d2) au moyen d'une différence entre le troisième état de charge (23) et le premier état de charge run 21), configuré pour déterminer une perte de capacité (dKap) à partir de la différence entre le premier déplacement de charge (d1) et le deuxième déplacement de charge (d2), pour déterminer une perte moyenne de capacité (dKap$_{Douleur\ moyenne}$) .

12. Appareil (1) selon la revendication 11, dans lequel l'unité de calcul (100) est configurée pour déterminer la capacité résiduelle (CR) à partir de la différence entre une capacité de départ (CS) et au moins une perte moyenne de capacité (dKap$_{Douleur\ moyenne}$) .

13. Dispositif (1) selon la revendication 11 ou 12, dans lequel l'unité de calcul (10) est configurée, le nombre (Z) de cycles de charge (100) basé sur les grandeurs utilisées pour déterminer la perte de capacité moyenne (dKap$_{Douleur\ moyenne}$) pertes de capacité (dKap).

14. Dispositif (1) Selon l'une des revendications 11 à 13, le dispositif comprend une chambre de contrôle de la température (3) qui convient à l'organisation du stockage sur batterie.

15. Produit de programme d'ordinateur (13) qui peut être chargé directement dans la mémoire d'une unité de calcul programmable (10), au moyen d'un code de programme, pour exécuter un procédé selon l'une des revendications 1 à 10 lorsque le produit de programme d'ordinateur (13) est exécuté dans l'unité de calcul (10).

FIG 1

FIG 2

## FIG 3

## FIG 4

FIG 5

FIG 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **YANZHI WANG et al.** Minimizing state-of-health degradation in hybrid electrical energy storage systems with arbitrary source and load profiles. *DESIGN, AUTOMATION & TEST IN EUROPE, EUROPEAN DESIGN AND AUTOMATION ASSOCIATION, IMEC VZW, KAPELDREEF 75 LEUVEN BELGIUM,* 24. Marz 2014, ISBN 978-3-9815370-2-4, 1-4